# EUROPEAN PATENT APPLICATION

(11) **EP 0 955 553 A2**
(43) Date of publication of application: **10.11.1999**
(21) Application number: 99109066.3
(22) Date of filing: 07.05.1999
(51) Int. Cl.: G01R 31/36

(54) **Apparatus and method for continuous monitoring of batteries**

(30) Priority: 08.05.1998 IT MO980100
(71) Applicant: S.P.E. Elettronica Industriale di Poletti Sergio, 40014 Crevalcore (BO) (IT)
(72) Inventor: Poletti, Sergio, 40014 Cravalcore (IT)
(74) Representative: Crugnola, Pietro

(57) **Abstract**

The apparatus for monitoring a battery (1) comprises first measuring means (RE2) for measuring the instantaneous voltage across the terminals (2, 3) of the battery (1), second measuring means (4, RE1) for measuring the instantaneous current delivered or absorbed by the battery (1), and further comprises processing means (ADC, MCP) capable of determining the quantity of electric charge delivered or absorbed by the battery.

The method for monitoring a battery (1) comprises measuring the instantaneous voltage across the terminals (2, 3) of the battery (1) and the instantaneous current delivered or absorbed by the battery (1), and further comprises determining the quantity of electric charge delivered and absorbed by the battery (1).

## Description

The invention relates to an apparatus and a method for continuous monitoring of batteries, in particular rechargeable batteries.

In the prior art the operation of a battery is monitored by measuring the voltage across the terminals of the battery in order to determine the battery's state of charge and in particular to signal to the user the need to recharge the battery.

However this monitoring technique is not very efficient because the voltage across the terminals remains substantially constant until the battery is close to being discharged. This technique is therefore unable to provide an indication of the residual charge of a battery until the battery is almost completely discharged, which is of little help to the user who needs to know moment by moment the state of charge of the battery and the instantaneous quantity of electric charge delivered by the battery during operation in order to be able to programme its use efficiently. Furthermore, while recharging a battery it is not possible with the known technique to obtain immediately usable information on the battery's recharging rate and the residual charging time.

The present invention aims to solve the aforesaid problems.

According to a first aspect of the invention there is provided an apparatus for monitoring a battery, comprising first measuring means for measuring the instantaneous voltage across the terminals of the battery and second measuring means for measuring the instantaneous current delivered or absorbed by the battery, characterised by the fact that it further comprises processing means capable of determining the quantity of electric charge delivered or absorbed by the battery.

According to another aspect of the invention there is provided a method for monitoring a battery comprising measuring the instantaneous voltage across the terminals of the battery and the instantaneous current delivered or absorbed by the battery, characterised by the fact that it further comprises determining the quantity of electric charge delivered and absorbed by the battery.

The invention will now be described below, as a purely illustrative and nonlimiting example, with reference to the attached drawings, in which:
figure 1 is a block wiring diagram of an apparatus according to the invention;
figure 2 is a front view of the data display panel of an apparatus according to the invention.

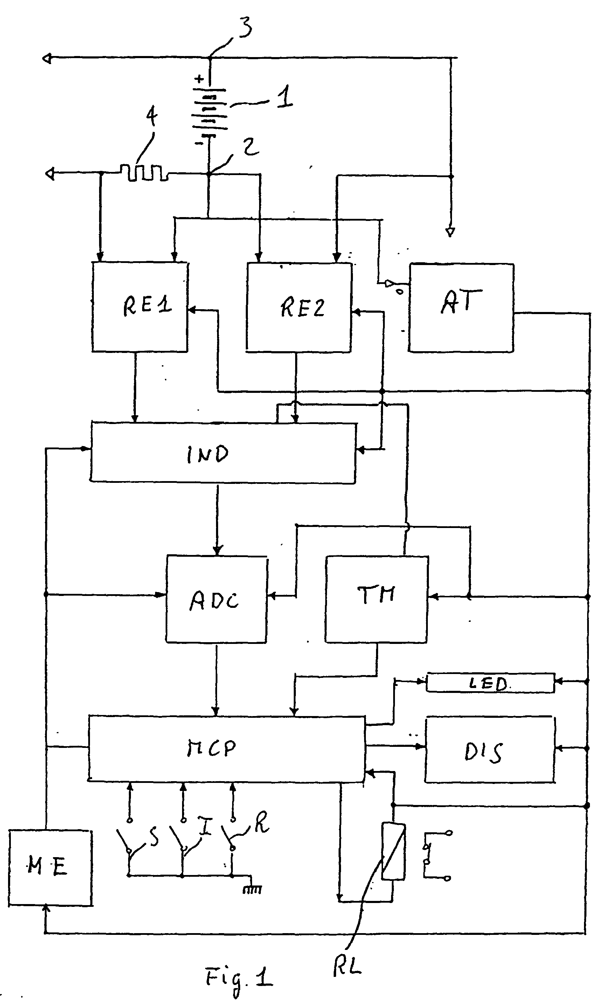

With reference to figure 1 the following are indicated: by 1 a battery, for example of the rechargeable type with terminals 2 and 3 connectable to the apparatus according to the invention. The apparatus according to the invention comprises a current sensor 4, for example a shunt or a Hall effect sensor, connected in series to one of the battery terminals and capable of generating a signal, for example a voltage signal, proportional to the intensity and the direction of the current delivered by the battery in the discharging phase, or absorbed by the battery in the charging phase.

The signal generated by the sensor 4 is sent to first signal detecting and processing means RE1, which detects the signal generated by the sensor 4 and processes it, in turn generating an analog signal proportional to the intensity and direction of the current delivered or absorbed by the battery 1.

Second detecting and processing means RE2 is connected in parallel with the terminals 2 and 3 of the battery 1 to detect the voltage across the terminals of the battery 1 and generate an analog signal proportional to said voltage.

The signals processed by the detecting and processing means RE1 and RE2 are sent to switch means IND, timed by a timer TM, which alternately enables, at predetermined time intervals, the forwarding of the analog signals coming from said detecting and processing means RE1, RE2 to an analog-digital converter ADC, which converts said analog signals into corresponding digital signals.

The digital signals generated by the analog-digital converter ADC are sent to a microprocessor MCP, also timed by the timer TM, in order to recognise whether the signal received by the converter ADC is proportional to the current delivered or absorbed by the battery 1 or to the voltage across the terminals of the battery.

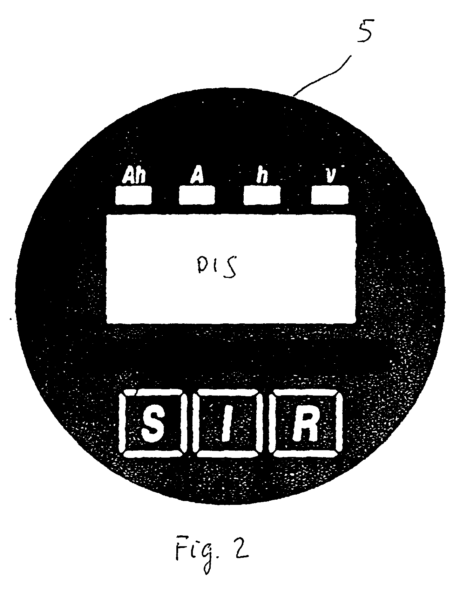

The microprocessor MCP is also connected to an electronic memory ME, for example a non-volatile electronic memory of the EEPROM type, to display means DIS capable of displaying signals processed by the microprocessor MCP, for example an LED or liquid crystal display, and to a series of indicators LED capable of indicating the various functions of the apparatus. The display means DIS and the indicators LED are mounted on a panel 5 of the apparatus according to the invention (figure 2). The indicators LED are marked in figure 2 with the symbols Ah, A, h and V respectively. The microprocessor MCP is also connected to a plurality of switches S, I and R, actuatable by way of corresponding keys on the panel 5 and respectively capable of selecting the type of signal processed by the microprocessor MCP and displayed on the display DIS, of allowing the microprocessor MCP to be programmed and of enabling the apparatus reset function.

The electronic memory ME memorises the characteristic operating parameters of the battery 1 according to which the microprocessor MCP processes the signals coming from the analog-digital converter ADC and generates the signals displayed on the display DIS which indicate the state of operation of the battery 1. The electronic memory ME can memorise for example the capacity of the battery 1 in ampere-hours; a value of residual capacity in ampere-hours on reaching which it is advisable to recharge the battery; a quantity of electric charge, in ampere-hours, which it is desired to introduce into the battery during the charging phase, and which may be different from the capacity of the battery, depending on the needs of the user; values of capacity of the battery according to the different intensities of the charging and discharging current.

The microprocessor MCP can also be connected to an optional switch RL, for example a relay switch, which is activated by the microprocessor MCP when the operation parameters of the battery 1 reach predetermined values. The relay switch RL serves to automatically interrupt the connection between the battery 1 and an external circuit which is fed by the battery or feeds the battery.

The apparatus according to the invention is powered by the same battery 1, by way of a power supply unit AT.

The apparatus according to the invention operates in the following manner.

When the battery is connected to an electrical circuit, by way of which the battery powers an electrical appliance, or by way of which the battery is powered for recharging, the current sensor 4 generates a signal proportional to the intensity and direction of the current delivered or absorbed by the battery 1, which is detected and processed by the first detecting and processing means RE1, which in turn generates an analog signal proportional to the intensity and direction of said current. The second detecting and processing means RE2 measures the intensity of the voltage across the terminals 2 and 3 of the battery and processes an analog signal proportional to the intensity of said voltage.

The two signals generated by the detecting and processing means RE1 and RE2 are sent, alternately, at predetermined time intervals, for example of the order of milliseconds, by way of the switch IND timed by the timer TM, to the analog-digital converter ADC, which converts the signal received by way of the switch IND into a corresponding digital signal and sends it to the microprocessor MCP.

The microprocessor MCP, according to the timing provided to it by the timer TM, first of all recognises whether the digital signal received by the analog-digital converter ADC is proportional to the current delivered or absorbed by the battery or to the voltage across the terminals of the battery and processes it in order to generate signals capable of being displayed on the display DIS and indicative of the operating parameters of the battery 1.

The signals processed by the microprocessor MCP may, for example, determine: displaying on the display DIS of the instantaneous voltage across the terminals of the battery 1, or the instantaneous current absorbed or delivered by the battery 1; displaying of the residual capacity of the battery in the discharging phase and/or the residual battery discharging time; displaying of the residual quantity of electric current to be introduced into the battery during charging and/or the residual battery charging time; the quantity of electric charge, in ampere-hours, delivered or absorbed by the battery.

Displaying of the value of the instantaneous voltage across the terminals of the battery 1 or the instantaneous current absorbed or delivered by the battery is determined by the microprocessor MCP by way of a signal processed according to the respective signals generated by the detecting and processing means RE1 and RE2 and by the analog-digital converter ADC.

Displaying of the quantity of electric charge in ampere-hours absorbed or delivered by the battery is determined by a signal processed by the microprocessor MCP according to the signal generated by the first detecting and processing means RE1.

The microprocessor MCP is also capable of calculating the residual capacity of the battery and the residual charging or discharging time of the battery using data memorised in the electronic memory MPE and causing them to be displayed on the display DIS.

For example, the residual capacity of the battery in the discharge phase can be calculated by the microprocessor MCP according to a nominal battery capacity value memorised in the memory MPE, the intensity of the instantaneous discharge current of the battery, and the time elapsed since discharge began.

Since the capacity of a battery is influenced by the discharge current, tending to fall with an increase in discharge current, it is advantageous that in the memory ME there are memorised, for example, a plurality of nominal battery capacity values according to the discharge current in such a way that the microprocessor MCP can calculate the residual capacity of the battery taking account of the differences in nominal capacity according to discharge current.

The microprocessor MCP is also able to calculate the residual discharge time of the battery as a function of the residual capacity and the instantaneous discharge current and to generate a signal that causes the residual discharge time of the battery to be displayed on the display means DIS.

The microprocessor is also capable of processing a signal for warning the user that the residual capacity of the battery or the residual discharge time have reached a minimum predetermined value, which can be memorised by the user in the memory ME according to requirements. This signal can also be used for activating the relay switch RL for the purpose of automatically interrupting the electrical connection between the battery and an appliance powered by the battery, when the residual capacity of the battery reaches the predetermined minimum value.

If a zero value of residual battery charge is memorised, the microprocessor MCP activates a relay switch RL when the voltage across the terminals of the battery 1 falls below a predetermined minimum value, which depends on the type of battery and is memorised in the memory ME, indicating complete discharge of the battery 1.

A further function of the microprocessor MCP is to program charging of the battery 1. In this case, the microprocessor MCP calculates the quantity of electric charge introduced into the battery as a function of the instantaneous charging current and the time elapsed since charging began and generates a signal that can be displayed on the display device DIS when the quantity of electric charge introduced into the battery reaches a predetermined value, memorised in the memory ME, which may correspond to the nominal capacity of the battery 1 or to some other value lower than the nominal capacity and established by the user according to his requirements. The aforesaid signal can also be used to activate the relay switch RL in order to automatically interrupt charging of the battery when the quantity of introduced electric charge has reached the predetermined value. If no predetermined value of the quantity of electric charge to be introduced into the battery during the charging phase is memorised, the microprocessor MCP activates the relay switch RL when the intensity of the current absorbed by the battery falls below a predetermined minimum value memorised in the memory ME and indicating that battery charging is completed.

Furthermore, the microprocessor MCP commands activation of the indicators Ah, A, h, V on the panel 5 of the apparatus according to the quantity displayed on the display DIS.

For example, when the quantity of electric charge absorbed or delivered by the battery 1 or the residual capacity of the battery 1 in the charging or discharging phases is displayed, the microprocessor MCP activates the indicator Ah, which emits a continuous luminous signal indicative of the function displayed on the display DIS. It may be envisaged that the luminous signal generated by the indicator Ah is of one colour, for example red, when the battery 1 is in the discharging phase and another colour, for example green, when the battery 1 is in the charging phase. The luminous signal emitted by the indicator Ah can also be made intermittent by the microprocessor MCP when the residual capacity of the battery in the discharging phase has reached the predetermined minimum value or when the quantity of electric charge introduced into the battery in the charging phase has reached the predetermined maximum value. The purpose of this is to warn the user that the aforesaid predetermined limit values have been reached. When the quantity displayed on the display DIS is the current delivered or absorbed by the battery 1, the microprocessor MCP activates the indicator A, which emits a corresponding luminous signal. Again in this case said luminous signal may be of one colour if the battery 1 is delivering current and another colour if the battery 1 is absorbing current.

The indicator V is similarly activated by the microprocessor MCP when an indication of the voltage across the terminals of the battery 1 appears on the display.

The indicator h indicates that the residual charging or discharging time of the battery 1 is displayed on the display DIS.

The choice of quantity to be displayed on the display device DIS, namely ampere-hours, current, voltage, time, is selected using the key S on panel 5 of the apparatus: pressing the key S repeatedly switches cyclically from one displayed quantity to the next quantity to be displayed, according to a predetermined sequence. The key S can also be used to switch the apparatus into the programming mode, namely the mode for introducing data into the memory ME. This function can be activated, for example, by holding down the key S for a predetermined time interval. Data can be introduced into the memory ME using the key I, which, for example, permits introduction of the values of nominal capacity of the battery 1, the predetermined residual capacity during the discharging phase and the quantity of electric charge to be introduced in the charging phase, incrementing a counter device with fixed increments every time the key I is pressed. The key R serves for resetting the apparatus, for example by pressing it simultaneously with the key S.

The apparatus according to the invention permits continuous and instantaneous monitoring of the operating parameters of any type of battery 1 and programming of the charging and discharging cycles of the battery 1.

Furthermore, operation of the apparatus does not depend on the type of construction technology of the battery since it is based on measurement of electrical quantities characteristic of the battery, such as absorbed or delivered current and the voltage across the terminals, and on the calculation of the quantity of electric charge absorbed or delivered by the battery.

In the practical implementation, the components used, the dimensions and the construction details may differ from those indicated while being technically equivalent to them, without departing from the scope of the present invention.

## Claims

1. Apparatus for monitoring a battery (1), comprising first measuring means (RE2) for measuring the instantaneous voltage across the terminals (2, 3) of the battery (1), second measuring means (4, RE1) for measuring the instantaneous current delivered or absorbed by the battery (1), characterised by the fact that it further comprises processing means (ADC, MCP) capable of determining the quantity of electric charge delivered or absorbed by the battery.

2. Apparatus according to claim 1, wherein said means (RE2) is capable of generating a first signal proportional to the intensity of said voltage.

3. Apparatus according to claim 1 or 2, wherein said second measuring means (4, RE1) is capable of generating a second signal proportional to the intensity and direction of said current.

4. Apparatus according to claim 2 or 3, wherein said first and second signal are of the analog type.

5. Apparatus according to claim 4, further comprising converter means (ADC) capable of converting said first and said second analog type signals into corresponding first and second digital type signals.

6. Apparatus according to claim 5, wherein said converter means comprises an analog-digital converter (ADC).

7. Apparatus according to one of claims 2 to 7, further comprising timed switch means (IND) capable of allowing said first and said second signal to be transmitted to said converter (ADC) alternately at predetermined time intervals.

8. Apparatus according to claim 7, wherein said timed switch means (IND) is associated with timer means (TM).

9. Apparatus according to one of claims from 5 to 8, wherein said first and second digital type signals are sent to said calculator means (MCP).

10. Apparatus according to one of previous claims, wherein said calculator means is associated with memory means (ME).

11. Apparatus according to claim 10, wherein said memory means (ME) comprises a non-volatile electronic memory.

12. Apparatus according to one of previous claims, wherein said calculator means is associated with display means (DIS).

13. Apparatus according to claim 12, wherein said display means (DIS) is capable of displaying signals generated by said calculator means (MCP) in alphanumerical form.

14. Apparatus according to claim 13, wherein said display means (DIS) comprises indicator means (Ah, A, h, V) which can be activated by said signals generated by said calculator means (MCP).

15. Apparatus according to claim 14, wherein said indicator means (Ah, A, h, V) are capable of emitting luminous signals.

16. Apparatus according to claim 14 wherein said luminous signals may be of continuous or intermittent type.

17. Apparatus according to claim 14 or 15, wherein each indicator means (Ah, A, h, V) is capable of emitting luminous signals of different colours.

18. Apparatus according to one of previous claims, wherein said calculator means (MCP) is associated with first switch means (RL) interposed between said battery (1) and an electrical circuit external to the battery (1).

19. Apparatus according to claim 18, wherein said calculator means (MCP) is capable of emitting signals for actuating said switch means (RL).

20. Apparatus according to one of previous claims, wherein said calculator means (MCP) is associated with second switch means (S, R, I) which can be activated manually.

21. Apparatus according to claim 20, wherein said second switch means (S, R, I) can be used for sending commands to said calculator means (MCP) and for introducing data into said memory means (ME).

22. Apparatus according to one of previous claims, comprising power supply means (AT) capable of electrically powering the apparatus itself by way of said battery (1).

23. Method for monitoring a battery (1) comprising measuring the instantaneous voltage across the terminals (2, 3) of the battery (1) and the instantaneous current delivered or absorbed by the battery (1), characterised by the fact that it further comprises determining the quantity of electric charge delivered or absorbed by the battery (1).

24. Method according to claim 23, further comprising comparing the value of said quantity of electric charge with data memorised in memory means (ME).

25. Method according to claim 24, further comprising processing said value of quantity of electric charge according to said data.

26. Method according to one of claims 23 to 25, further comprising generating an analog type signal proportional to the intensity of said instantaneous voltage.

27. Method according to one of claims 23 to 26, further comprising generating an analog type signal proportional to the intensity of said instantaneous current.

28. Method according to one of claims 23 to 27, further comprising alternately converting said analog signals into corresponding digital type signals at predetermined time intervals.

29. Method according to claim 27, wherein said digital type signals are used to determine the quantity of electric charge absorbed or delivered by the battery (1).

30. Method according to one of claims 23 to 9, further comprising generating a signal according to the quantity of electric charge absorbed or delivered by the battery (1).

31. Method according to claim 30, wherein said signal according to the quantity of electric charge absorbed or delivered by the battery (1) is capable of activating display means (DIS) and indicator means (Ah, A, h, V).

32. Method according to claim 30, characterised by the fact that said signal according to the quantity of electric charge absorbed or delivered by the battery (1) is capable of activating switch means (RL) interposed between said battery (1) and an electrical circuit external to said battery (1).
